Europäisches Patentamt

European Patent Office

Office européen des brevets

(11) Publication number: **0 267 730 B1**

# EUROPEAN PATENT SPECIFICATION

(45) Date of publication of patent specification: **18.03.92**  (51) Int. Cl.5: **H01L 21/285**, H01L 29/40

(21) Application number: **87309737.2**

(22) Date of filing: **04.11.87**

The file contains technical information submitted
after the application was filed and not included in
this specification

(54) **Tungsten metallization.**

(30) Priority: **10.11.86 US 929043**

(43) Date of publication of application:
**18.05.88 Bulletin 88/20**

(45) Publication of the grant of the patent:
**18.03.92 Bulletin 92/12**

(84) Designated Contracting States:
**DE FR GB IT**

(56) References cited:
**GB-A- 1 193 868**
**GB-A- 2 181 456**

**IBM TECHNICAL DISCLOSURE BULLETIN, vol.
24, no. 4, September 1981, pages 1976-1977,
New York, US; C.Y. TING: "Using titanium
nitride and silicon nitride for VLSI contacts"**

**JOURNAL OF THE ELECTROCHEMICAL SOCI-
ETY, vol. 133, no. 2, February 1986, pages
401-403, Manchester, New Hampshire, US; N.
YAMAMOTO et al.: "Fabrication of highly reli-
able tungsten gate MOS VLSI'S"**

(73) Proprietor: **AMERICAN TELEPHONE AND
TELEGRAPH COMPANY
550 Madison Avenue
New York, NY 10022(US)**

(72) Inventor: **Holschwandner, Lowell Henry
1140 Graham Street
Bethlehem Pennsylvania 18015(US)**
Inventor: **Rana, Virendra Vir Singh
1524 Red Maple Lane
Allentown Pennsylvania 18104(US)**

(74) Representative: **Johnston, Kenneth Graham et
al
AT&T (UK) LTD. AT&T Intellectual Property
Division 5 Mornington Road
Woodford Green Essex, IG8 OTU(GB)**

INSPEC ABSTRACT ACCESSION, no. A 87 113 437, Inspec, IEE, London, GB; "Thin layers of TiN and Al as glue layers for blanket tungsten deposition", lecture held by V. RANA et al during the workshop on tungsten and other refractory metals for VLSI applications, 12th-14th November 1986, Palo Alto, Ca., US. Published in "Proceedings of the 1986 workshop on tungsten and other refractory metals for VISI applications II.", E. Broadbent (editors), 1987, pages 187-195, Mater. Res. Soc., Pittsburgh, PA, US

I.E.E.E. TRANSACTIONS ON ELECTRON DEVICES, vol. ED-34, no. 4, April 1987, pages 746-752, New York, N.Y., US; S.S. COHEN et al.: "Mo/Al metallization for VLSI applications"

## Description

This invention relates to a method of fabricating an integrated circuit as described in Claim 1.

As the complexity of integrated circuits continues to increase, the dimensions of the components of the integrated circuits continue to decrease. Not only do device dimensions decrease, but the dimensions of the interconnects, that is, the lines and windows used to connect devices decrease. The windows are often termed vias by those skilled in the art. It is noted that the term window is sometimes applied only to the openings to the source, gate, or drain electrodes while the term via is applied to the opening between levels in multilevel metal structures.

As smaller devices typically use relatively shallower junction depths than do larger devices, the use of high temperature thermal processing to taper the vias by causing a dielectric material to flow eventually becomes impossible as the via dimensions decrease. Consequently, the vias that must be filled with metal not only have a high aspect ratio, that is, a high ratio of height to width, but their walls are also substantially vertical. Aluminum is difficult to deposit uniformly in such vias and poor step coverage results for conventional deposition techniques such as sputtering. This not only leads to possible discontinuities in the metal coverage but also makes planarization of the surface, frequently required for subsequent processing such as second level metallization, very difficult.

Accordingly, alternatives to aluminum have been sought for at least portions of the metallization. One commonly contemplated alternative metal is low pressure chemical vapor deposition (LPCVD) tungsten. LPCVD tungsten is a desirable alternative because it has a conformal step coverage. LPCVD tungsten also offers advantages for use as interconnects. Besides having conformal step coverage, it has high electromigration resistance, resistance to hillock formation and high temperature stability. Although many methods of depositing LPCVD tungsten have been proposed, they are all included within two generic categories which are conveniently termed selective and blanket.

Selective deposition typically relies upon the reaction of a gas, such as tungsten hexafluoride, with substrates, such as silicon, to leave tungsten on the silicon surface. Selective deposition is also possible on metals and silicides.

With blanket deposition, tungsten is deposited over the entire surface and then etched back so that tungsten ideally remains only in the vias or as, for example, interconnects. While this process is conceptually simple, tungsten does not adhere well to silicon dioxide and practical problems arise. For example, after the deposition has been completed, the tungsten film may simply peel off the silicon dioxide which is also an obviously undesirable result.

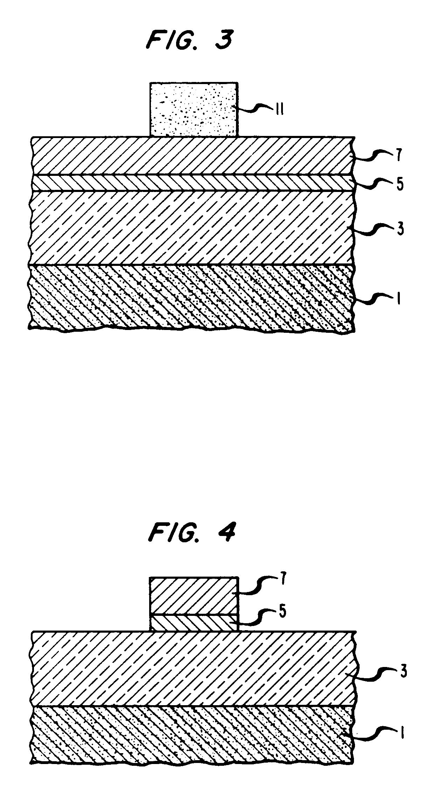

The use of a glue layer has been proposed to overcome the adhesion problem just discussed. A glue layer is a layer of material deposited prior to the tungsten and which has good adhesion both to the underlying dielectric layer and to the tungsten. Several substances have been proposed for glue layers. For example, the use of both elemental metals, such as Ti, and metallic silicides, such as $WSi_2$, has been proposed. See, for example, Comparison of Two Contact Plug Techniques for Use with Planarized Oxide and A Contact Filling Process with CVD-Tungsten for Multilevel Metallization Systems, Proceedings of the V-MIC Conference, pp. 403-410, and pp. 443-449, June 9-10, 1986, respectively. A common feature of the approaches adopted by these references in the use of relatively thick glue layers. Thicknesses of approximately 100 nm or more were used. It should be noted that the thickness of the Ti layer in the former reference is not explicitly given. However, Fig. 3 illustrates a plug after etching has been completed. It is evident that there is severe overetching of the glue layer which would not be visible if a thin glue layer had been used.

However, the use of a thick glue layer is undesirable because during the etch back step, severe undercutting of the tungsten layer occurs if, as is often the case, the glue layer etches more rapidly than does the tungsten. The undercutting may make subsequent processing very difficult. For example, voids may be left in the oxide and in subsequent metallizations after metal deposition.

Of course, the glue layer material should be electrically conducting. Only metals or silicides have been proposed as glue layer materials because of the rapid film growth in these materials. However, the use of some metals, such as aluminum, has not been seriously considered because a thick aluminum layer may cause spiking due to its rapid diffusion into the underlying material. Although from GB-A-1.193.868. it is known to use an evaporated aluminium layer to improve the adhesion of a Mo-metallization in semiconductor devices (see Claim 5). Other conducting compounds have not yet been proposed as glue layers.

We have found that tungsten can be blanket deposited with good adhesion over a dielectric covering a portion of a silicon surface by first depositing a film comprising either Al or a conducting nitride such as TiN as a glue layer. The glue layer film may be deposited, through openings in the dielectric, directly on the silicon or on a conducting material, such as a silicide, overlying the silicon. Of course, the glue layer is also deposited on the dielectric. Both TiN and Al films provide good adhesion down to thicknesses as small as approximately 3 nm. The minimum thickness is determined primarily by the requirement that the entire wafer surface be covered adequately. The thinner glue layers are generally preferred as they minimize any problems that might be caused by either spiking of deposited metal or undercutting during reactive sputter etching (RSE). However, if interaction of W with the substrate is to be prevented, a thicker layer of TiN may be used. To prevent spiking, the Al layer is typically less than 25 nm thick although the maximum thickness will be determined by device design and processing parameters. Uses other than plugs are contemplated. In particular, interconnects and gate structures are also contemplated.

Fig. 1 is a schematic representation of a exemplary metallization according to this invention;

Fig. 2 is a schematic representation of a via filled with tungsten after the etching step has been completed; and

Figs. 3 and 4 are schematic representations useful in explaining interconnects according to this invention.

For reasons of clarity, the elements of the devices depicted are not drawn to scale.

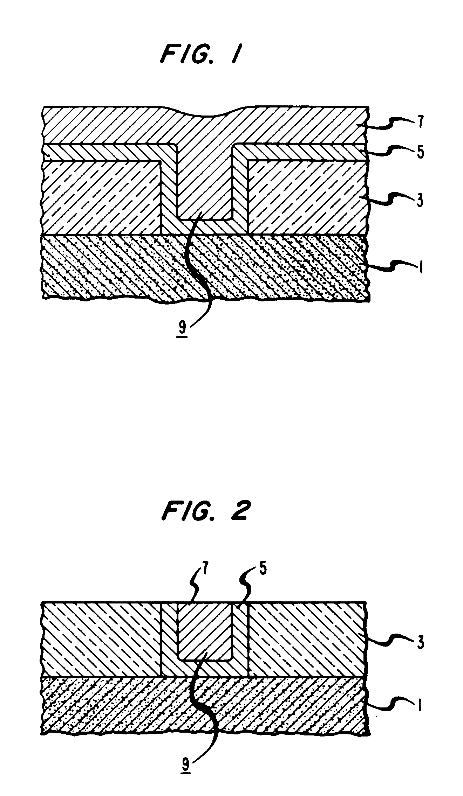

Our invention will be described by reference to Fig. 1 which is a schematic representation of a tungsten metallization according to this invention. Depicted are silicon layer 1, dielectric region 3, glue layer 5 and tungsten metallization 7. As can be seen, the glue layer and metallization extend into a via 9. The glue layer covers the interior surface of the via as well as the underlying silicon layer 1. The glue layer also covers the dielectric region 3. It will be readily appreciated that the individual components of the integrated circuit are not depicted for reasons of clarity.

The vias are formed by conventional VLSI processing steps which deposit, pattern and etch the dielectric, etc. These steps are well known to those skilled in the art and need not be described in detail. The dielectric region depicted comprises $SiO_2$ although it will be appreciated by those skilled in the art that other dielectric materials may be used. For example, B and P doped $SiO_2$ and $Si_3N_4$ might be used. It will also be appreciated that although layer 1 is described as silicon, other conducting materials might be used. For example, conducting silicides might be used. Such silicides are formed on the silicon surface. Thus, while the glue layer is described as being deposited over a silicon surface, the presence of other materials between the glue layer and the silicon surface is contemplated.

The glue layer is expediently deposited by well known techniques such as sputtering. The glue layer comprises at least one material selected from the group consisting of Al and conducting nitrides such as TiN. It will be appreciated that minor amounts of other materials may be present in the glue layer. For example, either or both Si and Cu may be present in Al. These materials are metallurgically stable with respect to the tungsten film. Good adhesion, as evidenced by an inability to remove the film by pulling on an attached adhesive tape, is obtained down to glue layer thicknesses of approximately 3 nm.

The native oxides on TiN and $Al_2O_3$ are thin. Although the successful use of Al might seem surprising in view of its strong susceptibility to oxide formation, it is believed that during the tungsten deposition most of the aluminum oxide present is removed although residues of non-conductive fluorides may remain. To prevent spiking, the Al layer should be less than approximately 25 nm thick. However, as will be readily appreciated by those skilled in the art, a precise maximum thickness cannot be given as it depends on several factors. These factors include the desired junction depth and the post Al deposition processing parameters. Given these factors, one skilled in the art can readily determine the maximum Al thickness.

The thinness of the glue layer is surprising but it must be noted, in retrospect, that pinholes in the glue layer need not be a significant problem. That is, the presence of some pinholes will not necessarily adversely affect the adhesive properties sought. It must also be remembered that, within the vias, pinholes are not significant as the electrical contact will still be formed if W goes through a pinhole at the bottom of the via provided that there is no chemical interaction with the substrate. For example, W interaction with, e.g., $TiS_2$, is not a problem. However, pinholes may be a problem for the W/Si interface although the interaction of W with a small amount of silicon can generally be tolerated. No adverse results occurs if the W touches the dielectric through a pinhole.

The growth of W films on the nitrides is surprising because it is hypothesized there are no displacement reactions which provide W nuclei for further film growth, i.e., the nitrides do not reduce $WF_6$. The Ti-N bonds are sufficiently strong so that the interaction of Ti with $WF_6$ is not energetically favored. The growth of W films on the nitride is believed to occur by the reduction of $WF_6$ with $H_2$, solely. Upon exposure to $WF_6$ and $H_2$, H and F atoms react and nucleate W on the surface. After the resulting islands coalesce, the growth rate of films is similar to the rates on Si or Al coated surfaces. The disadvantage of using a displacement reaction is that fluorides are formed at the interface.

Fig. 2 depicts a via after etching. Conventional etching techniques can be used for the etching steps. It should be remembered that the tungsten layer is typically overetched to guarantee its complete removal from areas not covered with resist in case there are non-uniformities in layer thickness. The overetch not only removes the tungsten but removes the thin glue layer contacting layer 1 without the need for any additional etching chemistry.

The absence of significant amounts of O and F at the W/TiN interface makes TiN ideally suited for use as a glue layer with etch-back plugs and interconnects.

The use of a thin layer also minimizes undercutting problems. It is apparent that a relatively planar surface is obtained in preparation for further processing. It should be noted that at most only a very thin layer of Al contacts the Si. This eliminates or minimizes the possibility of spiking which occurs with thicker Al films.

Other uses for our deposition process are contemplated. For example, it may be used to form interconnects or gate structures. The strong adhesion provided by thin glue layers is useful for patterning W interconnects. Fig. 3 is useful in explaining interconnect fabrication. Numerals identical to those used in Fig. 1 represent identical elements. Also depicted is patterned resist 11. To form interconnects, the tungsten and glue layers depicted are etched and the resist removed to yield the structure shown in Fig. 4. An Al layer under W interconnects should provide low resistance contacts. The use of Al is particularly suited for upper levels in multilevel metallization schemes where junction spiking is not a consideration. Also, it is suitable for very thin Al glue layers on Si contacts, as well as silicided junctions, where junction spiking may not occur.

## Claims

1. A method of fabricating an integrated circuit comprising the steps of: depositing tungsten over a silicon surface, at least a portion of said surface being covered with a dielectric, said tungsten covering said dielectric, depositing a glue layer before depositing said tungsten, which glue layer comprises at least one member selected from Al and conducting nitrides.

2. A method as recited in claim 1 further CHARACTERISED BY the step of patterning said dielectric layer to form holes.

3. A method as recited in claim 2, CHARACTERISED IN THAT said holes expose an electrically conducting material.

4. A method as recited in claim 3, CHARACTERISED IN THAT said material comprises said silicon surface.

5. A method as recited in claim 3, CHARACTERISED IN THAT said material comprises a metallic silicide.

6. A method as recited in claim 3, further CHARACTERISED BY etching said tungsten and said glue layer to form a planar surface of said dielectric and said tungsten in said hole.

7. A method as recited in claim 1, CHARACTERISED IN THAT said dielectric comprises silicon dioxide.

8. A method as recited in claim 1 further CHARACTERISED BY the step of patterning said tungsten and said glue layer.

## Revendications

1. Un procédé de fabrication d'un circuit intégré comprenant les étapes suivantes : on dépose du tungstène sur une surface de silicium, dont une partie au moins est recouverte par un diélectrique, le tungstène recouvrant ce diélectrique, et on dépose une couche adhésive avant de déposer le tungstène, cette couche adhésive comprenant au moins une substance sélectionnée parmi Al et des nitrures conducteurs.

2. Un procédé selon la revendication 1, CARACTERISE en outre par l'étape de définition d'un motif dans la couche diélectrique pour former des trous.

3. Un procédé selon la revendication 2, CARACTERISE EN CE QUE les trous précités mettent à nu un matériau conducteur de l'électricité.

4. Un procédé selon la revendication 3, CARACTERISE EN CE QUE le matériau précité est constitué par la surface de silicium précitée.

5. Un procédé selon la revendication 3, CARACTERISE EN CE QUE le matériau précité consiste en un siliciure métallique.

6. Un procédé selon la revendication 3, CARACTERISE en outre par le fait qu'on grave le tungstène et la couche adhésive pour former une surface plane sur le diélectrique et le tungstène dans le trou précité.

7. Un procédé selon la revendication 1, CARACTERISE EN CE QUE le diélectrique consiste en dioxyde de silicium.

8. Un procédé selon la revendication 1, CARACTERISE en outre par l'étape qui consiste à définir un motif dans le tungstène et la couche adhésive.

**Patentansprüche**

1. Verfahren zur Herstellung einer integrierten Schaltung mit folgenden Schritten:
Wolfram wird über eine Siliciumoberfläche abgeschieden;
mindestens ein Teil der Oberfläche ist mit einem Dielektrikum bedeckt;
das Wolfram bedeckt das Dielektrikum;
eine Haftschicht wird vor Niederschlagung des Wolframs abgeschieden und weist mindestens ein ausgewähltes Mitglied aus Aluminium und leitenden Nitriden auf.

2. Verfahren nach Anspruch 1,
gekennzeichnet durch den Schritt der Musterbildung der dielektrischen Schicht zur Bildung von Löchern.

3. Verfahren nach Anspruch 2,
dadurch gekennzeichnet, daß die Löcher ein elektrisch leitendes Material zugänglich machen.

4. Verfahren nach Anspruch 3,
dadurch gekennzeichnet, daß das Material die Siliciumoberfläche umfaßt.

5. Verfahren nach Anspruch 3,
dadurch gekennzeichnet, daß das Material ein metallisches Silicid aufweist.

6. Verfahren nach Anspruch 3,
dadurch gekennzeichnet, daß das Wolfram und die Haftschicht geätzt werden, um eine ebene Oberfläche des Dielektrikums und des Wolframs in dem Loch zu bilden.

7. Verfahren nach Anspruch 1,
dadurch gekennzeichnet, daß das Dielektrikum Siliciumdioxid umfaßt.

8. Verfahren nach Anspruch 1,
gekennzeichnet durch den Schritt der Musterbildung des Wolframs und der Haftschicht.

## FIG. 1

## FIG. 2

*FIG. 3*

*FIG. 4*